# EUROPEAN PATENT APPLICATION

(11) **EP 4 679 227 A1**
(43) Date of publication of application: **14.01.2026**
(21) Application number: 25187821.1
(22) Date of filing: 07.07.2025
(51) Int. Cl.: G06F 1/16, H04M 1/02, G09F 9/30

(54) **DISPLAY APPARATUS**

(30) Priority: 09.07.2024 KR 20240090668
(71) Applicant: Samsung Display Co., Ltd., Yongin-si, Gyeonggi-do 17113 (KR)
(72) Inventor: PARK, Dongjin, 17113 Giheung-gu, Yongin-si, Gyeonggi-do (KR); SEO, Dongwoo, 17113 Giheung-gu, Yongin-si, Gyeonggi-do (KR); YOON, Dongjin, 17113 Giheung-gu, Yongin-si, Gyeonggi-do (KR); LEE, Seokchan, 17113 Giheung-gu, Yongin-si, Gyeonggi-do (KR); CHOI, Sungchul, 17113 Giheung-gu, Yongin-si, Gyeonggi-do (KR)
(74) Representative: Dr. Weitzel & Partner

(57) **Abstract**

A display apparatus includes a folding area having a folding axis extending in a first direction and a non-folding area adjacent thereto. The folding area is foldable with respect to the folding axis. The display apparatus includes a display module including an upper surface having a display surface and a lower surface having a non-display surface. A window is on the upper surface of the display module. A housing accommodates the display module and the window. The housing includes a first housing surrounding a circumference of the display module and including a recessed portion recessed towards an inside of the first housing. A circumference of the window is disposed in the recessed portion. A second housing is separated from the first housing and disposed on the lower surface of the display module. The second housing is slidable with respect to the display module when the display module is folded.

## Description

The present invention relates to an apparatus, and more particularly, to a display apparatus.

Mobile electronic devices have become widely used along with the advancement of the information society. In addition to small electronic devices such as mobile phones, tablet personal computer (PCs) have recently been widely used as mobile electronic devices.

Mobile electronic devices may include a display panel to support various functions and provide visual information to the user, such as an image or a video. Recently, as other components for driving a display panel have been miniaturized, the proportion of the area occupied by a display panel in electronic devices has increased, and a structure for the display panel that is bendable to have a predetermined angle from a flat state is being development. The display panel is flexible so as to be bendable or foldable, and the flexible display apparatus may have a reduced weight and thickness.

However, during the folding of a display apparatus that includes a foldable display panel arranged inside a housing, an end of the display panel may slip and the position of the display panel may vary. Thus, a spare space may be provided in the housing to receive an end of the slipped display panel. Accordingly, the size of a non-display area of the display panel may be increased and the size of a display area of the display panel may be reduced.

One or more embodiments include a display apparatus that includes an increased display area of a display panel, is lightweight, and has increased durability.

However, the above embodiments are examples and are not limited thereto.

The invention is defined by the features of the independent claims. The dependent claims describe preferred embodiments. Additional aspects will be set forth in part in the description which follows and, in part, will be apparent from the description, or may be learned by practice of the presented embodiments of the invention.

According to an embodiment of the present invention, a display apparatus includes a folding area having a folding axis extending in a first direction and a non-folding area adjacent to the folding area. The folding area is foldable with respect to the folding axis. The display apparatus includes a display module including an upper surface having a display surface and a lower surface having a non-display surface. A window is disposed on the upper surface of the display module. A housing accommodates the display module and the window. The housing may also be termed as a housing assembly. The housing includes a first housing surrounding a circumference of the display module and including a recessed portion recessed towards an inside of the first housing. A circumference of the window is disposed in the recessed portion. A second housing is separated from the first housing and disposed on the lower surface of the display module. The second housing is slidable with respect to the display module when the display module is folded.

According to one or more embodiments, a width of the window in a second direction crossing the first direction may be greater than a width of the display module in the second direction.

According to one or more embodiments, the first housing may expose an upper portion of the window disposed in the recessed portion.

According to one or more embodiments, an adhesive member may fixedly attach a circumference of the window onto the recessed portion of the first housing and arranges a folding neutral surface on the window.

According to one or more embodiments, the adhesive member may surround a lower surface and a surface of the circumference of the window.

According to one or more embodiments, when the display apparatus is folded, layers of the display module disposed below the window may slip towards the folding axis, and layers of the display module disposed above the window may slip in a direction away from the folding axis.

According to one or more embodiments, a thickness of the window in the folding area may be less than a thickness of the window in the non-folding area.

According to one or more embodiments, the thickness of the window in a transformation area of the non-folding area adjacent to the folding area may gradually increase in a direction away from the folding area.

According to one or more embodiments, the display apparatus may further include a window planarization layer disposed on the window. The window planarization layer may have a thickness compensating for the thickness of the window. A sum of the thickness of the window planarization layer and the thickness of the window is the same in the folding area and in the non-folding area.

According to one or more embodiments, a thickness of a first portion of the window arranged in the recessed portion may be greater than a thickness of a second portion of the window not arranged in the recessed portion.

According to one or more embodiments, the first housing may include a first portion and a second portion protruding from an upper surface of the first portion to define the recessed portion.

According to one or more embodiments, which can be combined with the before and other embodiments, a display apparatus includes a folding area including a folding axis extending in a first direction and a non-folding area adjacent to the folding area. The display apparatus includes a display module foldable with respect to the folding axis. A window is disposed on an upper surface of the display module. The upper surface of the display module is a display surface. A housing accommodates the display module and the window. The housing includes a first housing surrounding a circumference of the display module and including a groove that is open from a lower portion of the first housing to an upper portion of the first housing. A second housing is disposed on a lower surface of the display module and includes an elastic portion disposed in the groove and protruding towards an upper portion of the groove.

According to one or more embodiments, the elastic portion may protrude in the groove towards the upper portion of the groove and bend in a direction towards the folding area. The elastic portion has a reverse "U" shape.

According to one or more embodiments, in a plan view, the elastic portion may be arranged on both sides of the second housing in a second direction crossing the first direction.

According to one or more embodiments, when the display apparatus is folded or unfolded, the elastic portion may reciprocate elastically in the second direction in the groove and the second housing may reciprocate in the second direction.

According to one or more embodiments, the second housing may be fixedly attached to the lower surface of the display module.

According to one or more embodiments, in a plan view, the elastic portion may extend in the first direction.

According to one or more embodiments, in a plan view, a plurality of elastic portions may be spaced apart from each other along the first direction.

According to one or more embodiments, the first housing may further include a hook portion extending in a direction away from the folding axis in the groove and protruding towards the upper portion of the groove. The hook portion has a "U" shape. The hook portion may be coupled to the elastic portion.

According to one or more embodiments, a circumference of the window may be disposed in and attached onto the first housing.

According to one or more embodiments, the first housing may expose an upper portion of the window arranged in the first housing.

According to one or more embodiments, the elastic portion may include a leaf spring.

According to one or more embodiments, an electronic device includes a display apparatus including a folding area comprising a folding axis extending in a first direction and a non-folding area adjacent to the folding area. The folding area is foldable with respect to the folding axis. The display apparatus includes a display module, comprising a window disposed on an upper surface of the display module. A housing accommodates the display module and the window therein. The housing comprises a first housing surrounding a circumference of the display module and comprising a recessed portion recessed towards an inside of the first housing. A circumference of the window is disposed in the recessed portion. A second housing is separated from the first housing and disposed on a lower surface of the display module. The second housing is slidable with respect to the display module when the display module is folded.

According to one or more embodiments, the window is fixedly attached to the recessed portion and a folding neutral surface is arranged on the window.

According to one or more embodiments, a thickness of the window in the folding area is less than a thickness of the window in the non-folding area.

According to one or more embodiments, the first housing includes a groove that is open from a lower portion of the first housing to an upper portion of the first housing. An elastic portion is disposed in the groove and protrudes towards an upper portion of the groove.

Other aspects, features, and advantages other than those described above will become apparent from the following detailed description, the appended claims, and the accompanying drawings.

The above and other aspects, features, and advantages of certain embodiments of the invention will be more apparent from the following description taken in conjunction with the accompanying drawings, in which:
FIGS. 1 and 2 are schematic perspective views of a display apparatus according to an embodiment of the present invention;
FIG. 3 is a schematic cross-section of the display apparatus according to an embodiment, taken along line III-III' of FIG. 1 according to an embodiment of the present invention;
FIG. 4 is a schematic cross-section of the display apparatus according to an embodiment of the present invention and illustrates an enlarged portion of the display apparatus of FIG. 3;
FIG. 5 is a schematic cross-sectional view of a cover window according to an embodiment of the present invention;
FIG. 6 is a schematic cross-sectional view of a display apparatus according to an embodiment of the present invention and may be similar to FIG. 4;
FIGS. 7A and 7B are schematic cross-sectional views of a display apparatus according to an embodiment of the present invention and may be similar to FIG. 4;
FIG. 8 is a schematic plan view of a display panel included in the display apparatus according to an embodiment of the present invention;
FIG. 9 is a schematic equivalent circuit diagram of a pixel circuit of the display panel and a display element connected to the pixel circuit according to an embodiment of the present invention; and
FIG. 10 is a schematic cross-sectional view of the display apparatus of FIG. 8, taken along line X-X' of FIG. 8 according to an embodiment of the present invention.

Reference will now be made in detail to non-limiting embodiments, examples of which are illustrated in the accompanying drawings, wherein like reference numerals refer to like elements throughout. In this regard, the described embodiments may have different forms and should not be construed as being limited to the descriptions set forth herein. Accordingly, non-limiting embodiments are merely described below, by referring to the figures, to explain aspects of the present description. As used herein, the term "and/or" includes any and all combinations of one or more of the associated listed items. Throughout the disclosure, the expression "at least one of a, b, or c" indicates only a, only b, only c, both a and b, both a and c, both b and c, all of a, b, and c, or variations thereof.

Since the present invention may have diverse modified embodiments, embodiments are illustrated in the drawings and are described in the detailed description. An effect and a characteristic of the invention, and a method of accomplishing these will be apparent when referring to embodiments described with reference to the drawings. The invention may, however, be embodied in many different forms and should not be construed as limited to the described embodiments set forth herein.

One or more embodiments will be described below in more detail with reference to the accompanying drawings. Those elements that are the same or are in correspondence are rendered the same reference numeral regardless of the figure number, and redundant descriptions thereof are omitted.

In the embodiments below, the terms "first" and "second" are not used in a limited sense and are used to distinguish one component from another component.

As used herein, the singular forms "a," "an," and "the" are intended to include the plural forms as well, unless the context clearly indicates otherwise.

Also, it will be understood that the terms "comprise," "include," and "have" used herein specify the presence of stated features or elements, but do not preclude the presence or addition of one or more other features or elements.

It will be understood that when a layer, region, or element is referred to as being "on" another layer, region, or element, it may be "directly on" the other layer, region, or element or may be "indirectly on" the other layer, region, or element with one or more intervening layers, regions, or elements therebetween. When a layer, region, or element is referred to as being "directly on" another layer, region, or element, no intervening elements may be present.

In the described embodiments hereinafter, it will be understood that when an element, an area, or a layer is referred to as being connected to another element, area, or layer, it can be directly and/or indirectly connected to the other element, area, or layer. In addition, in the specification, when a layer, region, component, or the like is electrically connected to another layer, region, component, or the like, the layer, region, component, or the like may be directly electrically connected thereto and/or may be indirectly electrically connected thereto with an intervening layer, region, component, or the like therebetween.

In the drawings, for convenience of description, sizes of components may be exaggerated or reduced. Since sizes and thicknesses of elements in the drawings may be arbitrarily illustrated for convenience of description, the described embodiments are not necessarily limited thereto.

In the following embodiments, the expression "A and/or B" indicates A, B, or A and B. Also, "at least one of A and B" indicates A, B, or A and B.

In the following embodiments, the expression "a line extends in a first direction or a second direction" may include a case in which "a line extends in a linear shape" and a case in which "a line extends in a zigzag or curved shape in a first direction or a second direction."

In the following embodiments, "in a plan view" refers to seeing a target portion from above. In the following elements, "in a cross-sectional view" refers to seeing a vertically cut cross-section of a target portion from the side. In the following embodiments, when a first element is referred to as "overlapping" a second element, it is understood that the first element is arranged over or under the second element.

In the following embodiments, the x-axis, the y-axis, and the z-axis are not necessarily limited to three axes of the rectangular coordinate system, and may be interpreted in a broader sense. For example, the x-axis, the y-axis, and the z-axis may be perpendicular to one another, or may represent different directions that are not perpendicular to one another.

When a certain embodiment may be implemented differently, a specific process order may be performed differently from the described order. For example, two consecutively described processes may be performed substantially at the same time or performed in an order opposite to the described order.

The present inventive concept is directed to a foldable display apparatus that includes a housing which increases the durability of the display apparatus and reduces the size of the non-display area of the display apparatus. The housing includes a first housing and second housing that are separated from each other. The second housing is slidable with respect to the display module. The window of the display module may be fixed on a recessed portion of the first housing. Since the display module is not attached to the second housing, a failure such as a crease may be prevented if the display module slips during the folding of the display apparatus and a spare area in the non-display area for receiving a portion of the slipped display module may not be required.

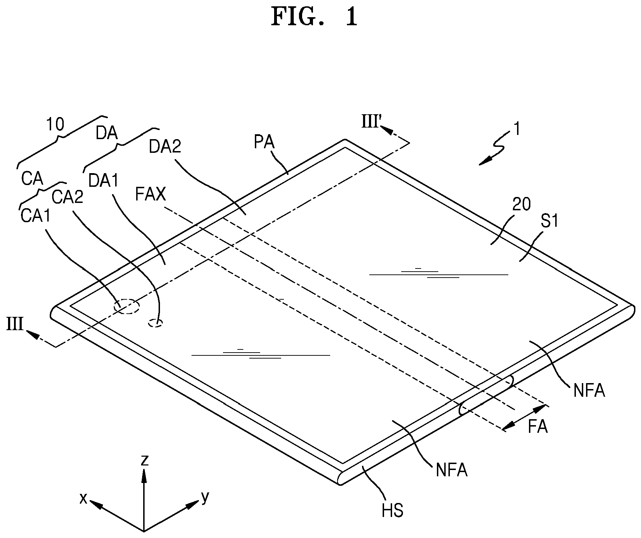

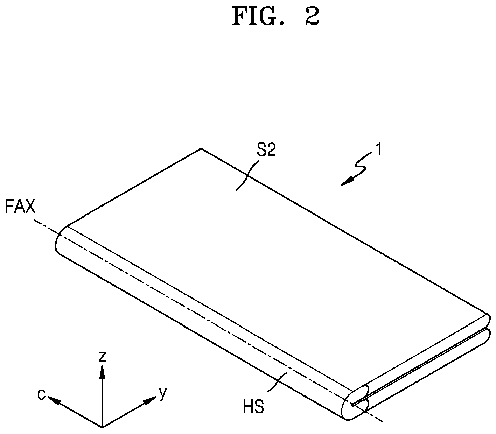

FIGS. 1 and 2 are schematic perspective views of a display apparatus according to embodiments of the present invention. In particular, FIG. 1 is a perspective view of a display apparatus 1 that is unfolded and FIG. 2 is a perspective view of a display apparatus 1 that is folded.

Referring to FIGS. 1 and 2, the display apparatus 1 may display at least one moving image and/or a still image, and may be used as displays of various electronic products, such as portable electronic devices such as a mobile phone, a smartphone, a tablet personal computer (PC), a mobile communication device, an electronic notepad, an electronic book, a portable multimedia player (PMP), a navigation device, and an ultramobile PC (UMPC), and a television, a notebook computer, a monitor, a billboard, and internet of things (IoT). In addition, the display apparatus 1 may be used in a wearable device, such as a smart watch, a watch phone, an eyewear display, and a head mounted display (HMD). In addition, the display apparatus 1 may be used as a dashboard of a vehicle, a center information display (CID) arranged in a center fascia or the dashboard of a vehicle, a mirror display replacing the rear view mirror and/or the side view mirror of a vehicle, and a display arranged on the rear of the front seat for entertainment for back seat passengers of a vehicle. However, embodiments of the present invention are not necessarily limited thereto and the electronic device that the display apparatus 1 may be applied to may be various different small-sized, medium-sized or large-sized electronic devices.

The display apparatus 1 may include a housing HS, a display panel 10, and a cover window 20.

The housing HS may include an inner side surface defining an accommodating space, such as a space for accommodating elements of the display apparatus 1. The housing HS may include a material having a relatively high rigidity. For example, in an embodiment the housing HS may include glass, plastic, or metal, or may include a plurality of frames and/or plates including a combination of the above materials. The housing HS may stably protect the elements of the display apparatus 1 accommodated therein from external impact.

The display panel 10 may display an image. The display panel 10 may include a display area DA, a component area CA, and a peripheral area PA. In an embodiment, the display area DA may be a main display area. A plurality of display elements may be arranged in the display area DA and may emit light. Therefore, the display panel 10 may display an image through light emitted from the plurality of display elements. In an embodiment, the display element may be an organic light-emitting diode including an organic emission layer. Alternatively, the display element may be a light-emitting diode LED. The size of the light-emitting diode LED may be on a micro scale or a nano scale. For example, the light-emitting diode LED may be a micro light-emitting diode. Alternatively, the light-emitting diode may be a nano light-emitting diode. For example, the nanorod light-emitting diode may include gallium nitride (GaN). In an embodiment, a color conversion layer may be disposed on the nano-rod light-emitting diode. The color conversion layer may include quantum dots. Alternatively, the display element may be a quantum dot light-emitting diode including a quantum dot emission layer. Alternatively, the display element may be an inorganic light-emitting diode including an inorganic semiconductor.

The component area CA is an area that displays an image and may overlap a component (e.g., an electronic component) for adding various functions. A plurality of display elements may be arranged in the component area CA. At least a portion of the component area CA may be surrounded by the display area DA (e.g., in a plan view). In an embodiment, the component area CA may be entirely surrounded by the display area DA (e.g., in a plan view). In an embodiment, the component area CA may include a first component area CA1 and a second component area CA2. In some embodiments, either one of the first component area CA1 and the second component area CA2 may be omitted. Additionally, in some embodiments the component area CA may include three or more component areas.

The peripheral area PA may surround at least a portion of the display area DA (e.g., in a plan view). For example, in an embodiment, in a plan view, the peripheral area PA may entirely surround the circumference of the display area DA. The peripheral area PA, as a non-display area, for example, may not display an image and various elements such as a driver for driving the display panel 10 and a printed circuit board may be arranged in the peripheral area PA.

The cover window 20 may protect the display panel 10. In an embodiment, the cover window 20 may be coupled to the housing HS to form an appearance of the display apparatus 1. The cover window 20 may include an insulating panel. For example, in an embodiment the cover window 20 may include glass, plastic, or a combination thereof. The cover window 20 may define the front surface of the display apparatus 1.

The cover window 20 may include an optically transparent area. Therefore, the display panel 10 may display an image through the optically transparent area of the cover window 20. In an embodiment, the transparent area may be surrounded by a bezel area and the shape of the transparent area may be defined by the bezel area. The light transmittance of the bezel area may be less than the light transmittance of the transparent area. In an embodiment, the bezel area may include an opaque material that blocks light. In an embodiment, the bezel area may have a predetermined color. In an embodiment, the bezel area may be defined by a bezel layer provided separately from a transparent substrate defining a transmissive area, or by an ink layer formed by being inserted or colored into the transparent substrate.

As shown in FIGS. 1 and 2, the display apparatus 1 may include a first surface S1 and a second surface S2 opposite to the first surface S1 (e.g., in the z-axis direction). The display apparatus 1 may display an image on the first surface S1. In an embodiment, the first surface S1 may be the front surface or upper surface of the display apparatus 1. The second surface S2 may be the rear side or lower side of the display apparatus 1 (e.g., in the z direction). In some embodiments, the display apparatus 1 may also display an image in the second surface S2.

The display apparatus 1 may be folded (e.g., is foldable) with respect to the folding axis FAX passing through the first surface S1. In an embodiment, in the display apparatus 1, a portion of the first surface S1 may be in direct contact with and may face another portion of the first surface S1 when the display apparatus 1 is folded (e.g., in-folded). In an embodiment, in the display apparatus 1, a portion of the second surface S2 may be in direct contact with and may face another portion of the second surface S2 when the display apparatus 1 is folded (e.g., out-folded). Hereinafter, for the convenience of description, descriptions are made based on cases in which a portion of the first surface S1 and another portion of the first surface S1 are in direct contact with each other to face each other, such as when the display apparatus 1 is in-folded. However, embodiments of the present invention are not necessarily limited thereto.

In an embodiment, the folding axis FAX may extend in the first direction. In some embodiments, the folding axis FAX may extend in the second direction crossing the first direction. In an embodiment, the first direction and the second direction may form an acute angle. In an embodiment, the first direction and the second direction may form a right angle or an obtuse angle. Hereinafter, detailed descriptions will be made based on embodiments in which the first direction (e.g., an x direction or a -x direction) crosses the second direction (e.g., the y direction or a -y direction)

FIGS. 1 and 2 show only one folding axis FAX. However, in some embodiments, the display apparatus 1 may include a plurality of folding axes FAX. In addition, although FIGS. 1 and 2 illustrate that the folding axis FAX extends in the first direction (e.g., the x direction or the -x direction), in some embodiments, the folding axis FAX may extend in the second direction (e.g., the y direction or the -y direction) or in a direction crossing the first direction (e.g., the x direction or the -x direction) and the second direction (e.g., the y direction or the -y direction).

The display apparatus 1 may include a housing HS, a display panel 10, and a cover window 20. The display panel 10 may include the display area DA and the component area CA. In an embodiment, the display area DA may include a first display area DA1 and a second display area DA2 with the folding axis FAX therebetween (e.g., in the y direction). The display panel 10 may include a folding area FA and a non-folding area NFA. The folding area FA may be portion of the first display area DA1 adjacent to the folding axis FAX and a portion of the second display area DA2 adjacent to the folding axis FAX. The folding area FA may be folded with respect to the folding axis FAX. The folding area FA may be arranged between the non-folding areas NFA (e.g., in the y direction). Unlike an embodiment shown in FIG. 1, there may be two or more folding areas FA in some embodiments. In an embodiment, although the area that cannot be folded is referred to as a non-folding area NFA for convenience of explanation, the non-folding area NFA may include an area having less flexibility than the folding area FA and having flexibility while being unfoldable, in addition to an area that is rigid due to not having flexibility. Additionally, the number of folding areas FA and non-folding areas NFA included in the display apparatus 1 may vary.

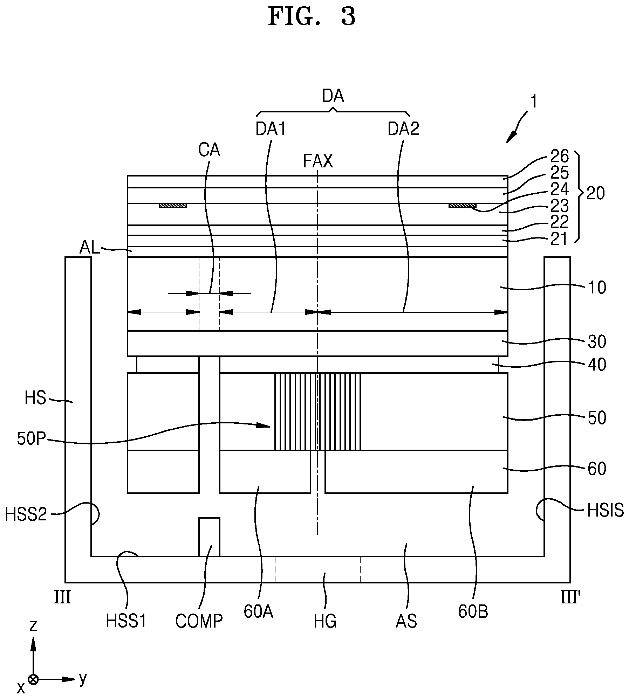

FIG. 3 is a schematic cross-section of the display apparatus according to an embodiment taken along line III-III' of FIG. 1.

Referring to FIG. 3, the display apparatus 1 may include the housing HS, the display panel 10, the cover window 20, a film layer 30, a support layer 40, a plate 50, a cushion layer 60, an adhesive layer AL, and a component COMP.

In an embodiment, the housing HS may include an inner side surface HSIS defining an accommodating space AS. The inner side surface HSIS of the housing HS may not form the appearance of the display apparatus 1. In an embodiment, the housing HS may have a rear surface HSS1 and a side surface HSS2. The rear surface HSS1 and the side surface HSS2 may not form the appearance of the display apparatus 1. In an embodiment, the display panel 10, the film layer 30, the support layer 40, the plate 50, the cushion layer 60, the adhesive layer AL, and the component COMP may face the inner side surface HSIS of the housing HS.

The elements of the display apparatus 1 may be arranged in the accommodating space AS. In an embodiment, the display panel 10, the film layer 30, the support layer 40, the plate 50, the cushion layer 60, the adhesive layer AL, and the component COMP may be arranged in the accommodating space AS. In an embodiment, the housing HS may include a hinge area HG overlapping the folding axis FAX. The display panel DP may be folded with respect to the folding axis FAX.

The display panel 10 may be arranged below the cover window 20 (e.g., in the -z direction). In an embodiment, the display panel 10 may be arranged in the accommodating space AS. Thus, the housing HS may cover the display panel 10. The display panel 10 may include the display area DA and the component area CA. In an embodiment, the component area CA may overlap the component COMP (e.g., in the z direction). In an embodiment, the display area DA may include the first display area DA1 and the second display area DA2 with the folding axis FAX therebetween. In addition, the display panel 10 may include the folding area FA and the non-folding area NFA. The folding area FA may be portion of the first display area DA1 adjacent to the folding axis FAX and a portion of the second display area DA2 adjacent to the folding axis FAX. The folding area FA may be arranged between the non-folding areas NFA (e.g., in the y direction).

The cover window 20 may be disposed on the display panel 10. In an embodiment, the cover window 20 may be disposed on the housing HS. In an embodiment, the cover window 20 may be connected to the housing HS. In an embodiment, the cover window 20 may include a window 21, a window planarization layer 22, a window adhesive layer 23, an opaque layer 24, a window protection layer 25, and a hard coating layer 26.

In an embodiment, the window 21 may include an ultra-thin glass.

The planarization layer 22 may be disposed on the window 21 such that a surface of the window 21, for example, the upper surface of the window 21, may be planarized. The window planarization layer 22 may be arranged between the window 21 and the window protection layer 25 (e.g., in the z direction). In an embodiment, the window planarization layer 22 may include a polymer resin. In some embodiments, the window planarization layer 22 may be omitted.

The window protection layer 25 may protect the window 21 and prevent or reduce scratches on the upper surface of the window 21. The window protection layer 25 may be disposed on the window 21. In an embodiment, the window protection layer 25 may include a polymer resin. In some embodiments, the window protection layer 25 may include an inorganic substance.

In an embodiment, the window adhesive layer 23 may be arranged between the window protection layer 25 and the window planarization layer 22 (e.g., in the z direction). The window adhesive layer 23 may adhere the window protection layer 25 onto the window planarization layer 22. In an embodiment, the window adhesive layer 23 may be a pressure sensitive adhesive. In some embodiments, the window adhesive layer 23 may be an optically clear adhesive.

The opaque layer 24 may be arranged between the window adhesive layer 23 and the window protection layer 25 (e.g., in the z direction). In some embodiments, the opaque layer 24 may be a portion of the window protection layer 25. The opaque layer 24 may include an opaque material such that the wiring or circuit of the display panel 10 cannot be identified from the outside. Thus, the opaque layer 24 may be a bezel area of the cover window 20.

The hard coating layer 26 may be disposed on the window protection layer 25. The hard coating layer 26 may be the outermost layer of the cover window 20 (e.g., in the z direction). The hard coating layer 26 may be the outermost layer of the display apparatus 1. The hard coating layer 26 is a layer that users touch directly and may provide a surface having a smooth and soft touch. In an embodiment, the hard coating layer 26 may include a polymer resin. In some embodiments, the hard coating layer 26 may include an inorganic material.

The film layer 30 may be disposed under the display panel 10 (e.g., in the -z direction). In an embodiment, the display panel 10 may be arranged between the cover window 20 and the film layer 30 (e.g., in the z direction). The film layer 30 may protect the display panel 10 from external impact. In an embodiment, the film layer 30 may include a polymer material. For example, in an embodiment the film layer 30 may include at least one of polyethersulfone, polyacrylate, polyetherimide, polyethylene naphthalate, polyethylene terephthalate, polyphenylene sulfide, polyimide, polycarbonate, and cellulose acetate propionate. In some embodiments, the film layer 30 may include an inorganic material.

The support layer 40 may be disposed under the film layer 30 (e.g., in a -z direction). In an embodiment, the film layer 30 may be arranged between the display panel 10 and the support layer 40 (e.g., in the z direction). The support layer 40 may be disposed below the display panel 10 so as to support the display panel 10. The support layer 40 may include a polymer material. In an embodiment, the support layer 40 may include a polymer resin such as polyethylene terephthalate or polyimide.

The plate 50 may be disposed under the support layer 40 (e.g., in the -z direction). In an embodiment, the support layer 40 may be arranged between the film layer 30 and the plate 50 (e.g., in the z direction). The plate 50 may be disposed under the support layer 40 so as to support the display panel 10. Accordingly, a degree to which the center portion of the display panel 10 droops in the -z direction due to the weight thereof is reduced, and thus, the display panel 10 may not be easily damaged even by an external impact.

In an embodiment, the plate 50 may include a folding pattern 50P. The shape or length of the folding pattern 50P may vary when the display apparatus 1 is folded. For example, in an embodiment the folding pattern 50P may be an opening provided in the plate 50. In some embodiments, the folding pattern 50P may have a concave-convex shape. In some embodiments, the folding pattern 50P may include links that are rotatably connected to each other.

In an embodiment, when the display apparatus 1 is folded, the folding pattern 50P may be folded with respect to the folding axis FAX. In an embodiment, both sides of the folding pattern 50P may be symmetrical with respect to the folding axis FAX. In an embodiment, the plate 50 may have a flat upper surface in an area not including the folding pattern 50P.

In an embodiment, the plate 50 may include at least one of metal, glass and plastic. For example, in an embodiment, the plate 50 may include polyurethane. In some embodiments, the plate 50 may include carbon fiber reinforced plastic (CFRP).

In an embodiment, a digitizer may be arranged between the plate 50 and the cushion layer 60 (e.g., in the z direction). The digitizer may include a body layer and/or a pattern layer. In an embodiment, the digitizer may detect a signal input from an external electronic pen through the pattern layer. For example, the digitizer may detect the strength, direction, etc. of the signal input from the electronic pen. In this embodiment, the digitizer may include a first digitizer and a second digitizer that are spaced apart from each other with respect to the folding axis FAX. Thus, damage to the digitizer when the display apparatus 1 is folded may be prevented or reduced.

The cushion layer 60 may be disposed under the plate 50 (e.g., in the -z direction). The cushion layer 60 may prevent or reduce the display apparatus 1 from being damaged by an external impact. For example, for the display apparatus 1 to be folded with respect to the folding axis FAX, the thickness (in a z-axis direction) of the elements included in the display apparatus 1 needs to be relatively small. For example, the thickness (in the z-axis direction) of the display panel 10 needs to be relatively small. However, when the thickness (in the z-axis direction) of the display panel 10 is relatively small, the display panel 10 may be easily damaged by an external impact. The cushion layer 60 may absorb the external impact applied to the display panel 10, thereby preventing or reducing damage to the display panel 10 by an external impact.

In an embodiment, the cushion layer 60 may include a material having viscoelasticity. For example, in an embodiment the cushion layer 60 may include at least one of polyurethane, polyacrylate, and polyethylene. For example, the cushion layer 60 may include at least one of urethane resin, acrylate resin, and ethylene-based resin. The cushion layer 60 may have a single-layer or multi-layer structure and may include a foam material similar to a sponge. In an embodiment, the cushion layer 60 may further include a pressure sensitive adhesive. In an embodiment, the cushion layer 60 may include a first portion 60A and a second portion 60B that are spaced apart from each other with respect to the folding axis FAX.

The adhesive layer AL may be arranged between the first element and the second element of the display apparatus 1. The adhesive layer AL may adhere the first element to the second element. In an embodiment, the adhesive layer AL may be a pressure sensitive adhesive. In some embodiments, the adhesive layer AL may be an optically clear adhesive. The adhesive layer AL may be arranged between the cover window 20 and the display panel 10 (e.g., in the z direction) so as to adhere the cover window 20 to the display panel 10. In addition, in an embodiment other adhesive layers may be arranged between other layers so as to adhere both layers to each other.

In an embodiment, the support layer 40, the plate 50, and the cushion layer 60 may each include a via-hole overlapping the component area CA. In this embodiment, the acoustic transmittance and/or light transmittance reaching from the outside to the component COMP may increase. In some embodiments, at least one of the support layer 40, the plate 50, and the cushion layer 60 may not include a via-hole overlapping the component area CA. In an embodiment, the film layer 30 may be continuously arranged in the display area DA and the component area CA. In this embodiment, the film layer 30 may protect the display panel 10. In some embodiments, the film layer 30 may include a via-hole overlapping the component area CA.

The component COMP may be arranged between the housing HS and the display panel 10. In an embodiment, the component COMP may be attached to the housing HS. In some embodiments, the component COMP may be arranged in the accommodating space AS. The component COMP may include an electronic module. For example, in an embodiment the electronic module may include a sensor configured to receive and use light, such as an infrared sensor, a camera configured to receive light and capture an image, a sensor configured to output and sense light or sound to measure a distance or recognize a fingerprint, a small lamp configured to output light, and/or a speaker configured to output sound. However, embodiments of the present invention are not necessarily limited thereto and the component COMP may be various different electronic modules. In an embodiment in which the electronic module uses light, the electronic module may use light of various wavelength ranges, such as visible rays, infrared rays, and/or ultraviolet rays.

In an embodiment, the component COMP may include a light-emitting module and a light-receiving module. The light-emitting module and the light-receiving module may have an integrated structure or may be a physically separated structure so that a pair of the light-emitting module and the light-receiving module may constitute one component COMP.

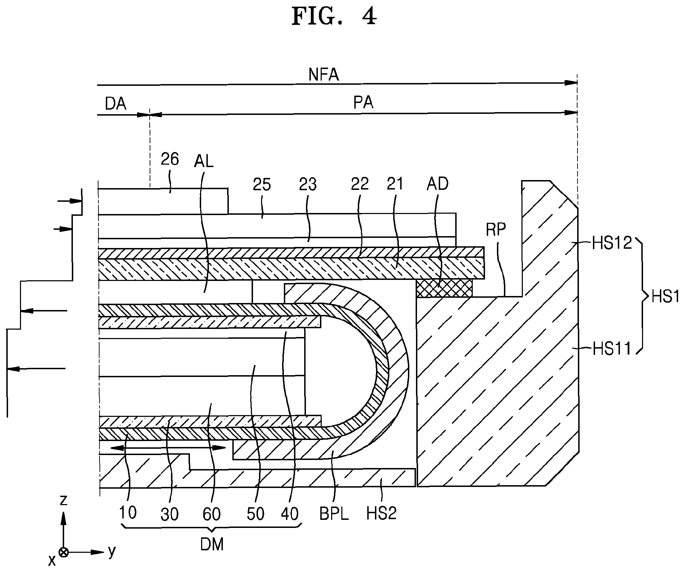

FIG. 4 is a schematic cross-section of the display apparatus according to an embodiment and illustrates an enlarged portion of the display apparatus of FIG. 3. In particular, FIG. 4 is a view showing an enlarged portion of the right side, for example, the +y direction side, of FIG. 3.

Referring to FIG. 4, as described above, the cover window 20, the display panel 10, the film layer 30, the support layer 40, the plate 50, and the cushion layer 60 may be accommodated in the housing HS, such as in the accommodating space AS.

The cover window 20 may protect the display panel 10. The cover window 20 may cover not only the display area DA but also the peripheral area PA.

In an embodiment, the display panel 10, the film layer 30, the support layer 40, the plate 50, and the cushion layer 60 may be defined as a display module DM. For example, the display module DM may include the display panel 10, the film layer 30, the support layer 40, the plate 50, and the cushion layer 60. The display module DM may include a first surface (e.g., the +z direction surface) and a second surface (e.g., the -z direction surface) facing the first surface. In FIG. 4, the first surface of the display module DM may correspond to the upper surface and the second surface of the display module DM may correspond to the lower surface.

The display panel 10 may be arranged below the cover window 20. In an embodiment, a portion of the display panel 10 may bend (e.g., be configured in a bent orientation). For example, in an embodiment the display panel 10 may bend on one side of the two sides of the display panel 10 with respect to the folding axis FAX. FIG. 4 shows that the display panel 10 bends on the right side (the +y direction) with respect to the folding axis FAX. However, embodiments of the present invention are not necessarily limited thereto and the orientation of the folding axis FAX and the bendable portion of the display panel 10 may vary. In this embodiment, the display panel 10 may bend in the peripheral area PA and a bending portion of the display panel 10 may be defined as a bending area. The display panel 10 may bend in the bending area and a portion of the display panel 10 may face the other portion of the display panel 10, and the other portion of the display panel 10 may be disposed below a portion of the display panel 10. In this embodiment, the plate 50 and the cushion layer 60 may be arranged (e.g., in the z direction) between a portion of the display panel 10 and another portion of the display panel 10. In addition, a pad portion may be arranged in another portion of the display panel 10 and the pad portion may be connected to the printed circuit board.

In an embodiment, in the bending area where the display panel 10 is bent, a bending protective layer BPL may be arranged to prevent cracks of the display panel 10. In an embodiment, the bending protective layer BPL may include a polymer resin such as, for example, polyethyelene terephthalate (PET) and polyimide (PI). The bending protection layer BPL may cover the bending area of the display panel 10.

The film layer 30 may be disposed under the display panel 10 (e.g., in a -z direction). The film layer 30 may not be arranged in the bending area of the display panel 10. For example, the film layer 30 may include an opening corresponding to the bending area of the display panel 10. Accordingly, the film layer 30 may be arranged in each of a portion of the display panel 10 and the other portion of the display panel 10, and the plate 50 and the cushion layer 60 may arranged therebetween.

The housing HS may accommodate the cover window 20 and the display module DM. In an embodiment, the housing HS may be fixedly connected to another module, such as a case. In an embodiment, the housing HS may include a first housing HS1 and a second housing HS2.

The first housing HS1 may be arranged along the circumference of the display module DM. In an embodiment, the first housing HS1 may extend along the perimeter of the display module DM (e.g., in a plan view) and may shield a side of the display module DM. For example, in an embodiment, in a plan view, the first housing HS1 may surround the entire circumference of the display module DM.

In this case, in an embodiment, the first housing HS1 may have a recessed portion RP that is recessed towards the inside of the first housing HS1. For example, the first housing HS1 may include a first portion HS11 and a second portion HS12. The first portion HS11 may be arranged along the circumference of the display module DM. For example, the first portion HS11 may surround the display module DM, particularly, the side of the display module 10 and may be co-planar with display module. The second portion HS12 may protrude from the upper surface of the first portion HS11 (e.g., in the z direction) and at least a portion of the second portion HS12 may not be co-planar with the display module DM. The second portion HS12 may protrude from the outside of the upper surface of the first portion HS11 and accordingly, the recessed portion RP may be formed inside the upper surface of the first portion HS11 and may be defined by the first portion HS11 and the second portion HS12.

The cover window 20, for example, the circumference of the window 21, may be arranged in the recessed portion RP. The cover window 20, for example, the circumference of the window 21, may be arranged in the upper surface of the first portion HS11 and the recessed portion RP may expose the upper portion of the cover window 20. In this embodiment, the area of the cover window 20 (e.g., in a plan view) may be greater than the area of the display module DM (e.g., in a plan view). For example, in an embodiment a width of the window 21 of the cover window 20 in the second direction (e.g., the y direction), may be greater than the width of the display module DM in the second direction (e.g., the y direction). In an embodiment, the cover window 20, for example, the circumference of the window 21, may be fixedly attached onto the recessed portion RP through the adhesive member AD. The adhesive member AD may be arranged between the lower surface of the window 21 and the upper surface of the first portion HS11 (e.g., in the z direction).

In an embodiment in which the circumference of the window 21 is fixed on the recessed portion RP, a folding neutral surface, which does not slip when the display apparatus 1 is folded, may be arranged in the window 21.

The second housing HS2 may be disposed to cover the lower surface of the display module DM. In an embodiment, the second housing HS2 may cover the lower surface of the display module DM and may be fixedly connected to another module such as a case. In an embodiment, the second housing HS2 may be a separate member from the first housing HS1. For example, the first housing HS1 and the second housing HS2 may not be physically connected to each other. Accordingly, the second housing HS2 may slide (e.g., is slidable) relative to the lower surface of the display module DM as the display apparatus 1 is folded.

For example, in an embodiment as described above, the folding neutral surface may be arranged in the window 21 as the circumference of the window 21 is fixed on the recessed portion RP. When the display apparatus 1 is folded such that the display surfaces face each other with respect to the folding axis FAX, layers disposed below the window 21, which is the folding neutral surface, may slip in a direction (e.g., the -y direction) towards the folding axis FAX, and layers disposed on the window 21, which is the folding neutral surface, may slip in a direction (e.g., the +y direction) away from the folding axis FAX. In this embodiment, the degree by which each layer slips may depend on the distance between the folding neutral surface and each layer. For example, the cushion layer 60, which is spaced apart from the folding neutral surface more than the display panel 10 is spaced apart from the folding neutral surface, may slip more than the display panel 10. In this embodiment, since the second housing HS2 is fixed to another module, the display module DM and the second housing HS2 may slide relatively to each other as the display module DM slips.

According to embodiments as described above, as the window 21 is attached and fixed to the recessed portion RP, the window 21, as the folding neutral surface, may not slip. Accordingly, the second portion HS12 of the first housing HS1 may be positioned more adjacent to the circumference of the window 21, thereby reducing the area of the non-display area. As a comparative example, if the folding neutral surface is not the window 21, for example, if the lower surface of the display module DM is set to be the folding neutral surface, since the window 21 slips in a direction (e.g., the +y direction) away from the folding axis FAX, a predetermined spare distance is required between the second portion HS12 and the circumference of the window 21. The above arrangement may increase the area of the non-display area result in an increase in the size of the display apparatus 1.

In addition, according to embodiments, as the window 21 is set to be the folding neutral surface, the lower layer of the display module DM, for example, the cushion layer 60, may slip. However, since the display module DM is not attached to the second housing HS2, the display module DM may slide without restraint on the second housing HS2. Thus, a failure such as a crease may be prevented even when the display module DM slips during the folding of the display apparatus 1.

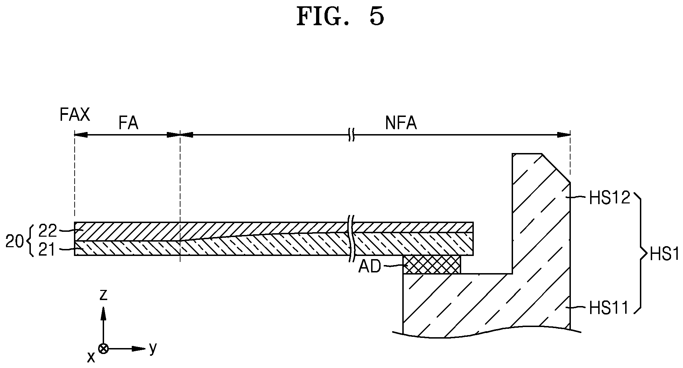

FIG. 5 is a schematic cross-sectional view of a cover window according to an embodiment. FIG. 5 is an enlarged view of the cover window 20 of FIG. 4.

Referring to FIG. 5, the thickness of the window 21 (e.g., length in the z direction) according to an embodiment may vary. In an embodiment, the thickness of the window 21 in the folding area FA may be less than the thickness of the window 21 in the non-folding area NFA. For example, in an embodiment the window 21 may have a consistent first thickness in the folding area FA and a consistent second thickness in the non-folding area NFA, and the first thickness may be less than the second thickness. In an embodiment as shown in FIG. 5, in a portion of the non-folding area NFA adjacent to the folding area FA which is a transformation area, the thickness of the window 21 may gradually increase from the first thickness to the second thickness in a direction away from the folding area FA. As described above, as the thickness of the window 21 in the folding region FA is less than the thickness of the window 21 in the non-folding area NFA, the folding of the window 21 may be further facilitated.

The window planarization layer 22 may be disposed on the window 21 (e.g., disposed directly thereon in the z direction). In an embodiment, the window planarization layer 22 may compensate for the different thicknesses of the window 21 by having a thickness that varies such that the sum of the thickness of the window flat layer 22 and the thickness of the window 21 is consistent in the folding area FA and the non-folding area NFA. For example, the thickness of the window planarization layer 22 in the folding area FA may be greater than the thickness of the window planarization layer 22 in the non-folding area NFA. For example, in an embodiment the window planarization layer 22 may have a consistent third thickness in the folding area FA and a consistent fourth thickness in the non-folding area NFA, and the third thickness may be less than the fourth thickness. In this embodiment, in the non-folding area NFA adjacent to the folding area FA, the non-folding area NFA being a transformation area, the thickness of the window planarization layer 22 may gradually decrease from the third thickness to the fourth thickness as the distance from the folding area FA increases in the transformation area. As described above, as the thickness of the window planarization layer 22 varies, the upper portion of the window 21 may be planarized, and the path of light may not vary, even when the thickness of the window 21 varies.

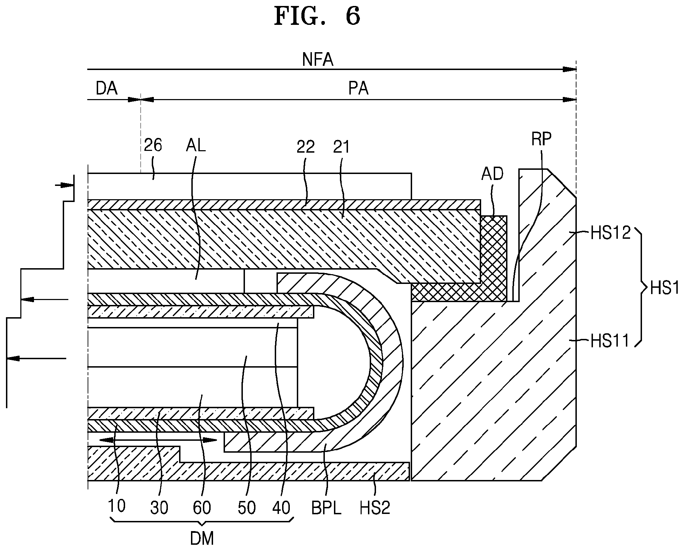

FIG. 6 is a schematic cross-sectional view of a display apparatus according to an embodiment and may be similar to FIG. 4. Since the display apparatus according to an embodiment is similar to the display apparatus described above, only differences between the two display apparatuses are described below.

Referring to FIG. 6, in an embodiment, the thickness (e.g., length in the z direction) of a portion (e.g., a first portion) of the window 21 arranged in the recessed portion RP may be greater than the other portion (e.g., a second portion) of the window 21 that is not arranged in the recessed portion RP. For example, as described above, the window 21 may have the second thickness in the non-folding area NFA. In this embodiment, the window 21 may be arranged in the recessed portion RP of the first housing HS1 in the peripheral area PA, as described above. In an embodiment, the thickness of a portion of the window 21 arranged in the recessed portion RP may be a fifth thickness and the fifth thickness may be greater than the second thickness. In an embodiment, a portion of the window 21 having the fifth thickness may be the circumference of the window 21. In addition, a portion of the window 21 arranged in the recessed portion RP may protrude downwards (e.g., in the -z direction) so as to have the fifth thickness greater than the second thickness. For example, the upper surface of the window 21 in the peripheral area PA may be a consistent plane and the window 21 may have a protruding lower surface. As described above, since the thickness of the portion of the window 21 arranged in the recessed portion RP is greater than the thickness of the portion of the window 21 that is not arranged in the recessed portion 21, the strength of the outer circumference of the display apparatus 1 may be increased.

In addition, in an embodiment, the thickness of the window 21, for example, the thickness of the non-folding region NFA, that is, the second thickness, may be in a range of about 90 µm to about 110 µm. In this embodiment, the window protection layer 25 may be omitted and the entire thickness of the display apparatus 1 may be decreased.

In an embodiment, the adhesive member AD for attaching and fixing the window 21 onto the first housing HS1 may include a resin material. In an embodiment, the adhesive member AD may surround both the lower surface and the circumferential surface (e.g., the lateral end) of the window 21 arranged in the recessed portion RP. In a cross-sectional view, the adhesive member AD may be arranged in an approximately "L" shape so as to surround the window 21. Accordingly, the window 21 may be more firmly attached and fixed onto the first housing HS1 and the window 21 may be prevented from being separated from the adhesive member AD and causing a failure such as a crease.

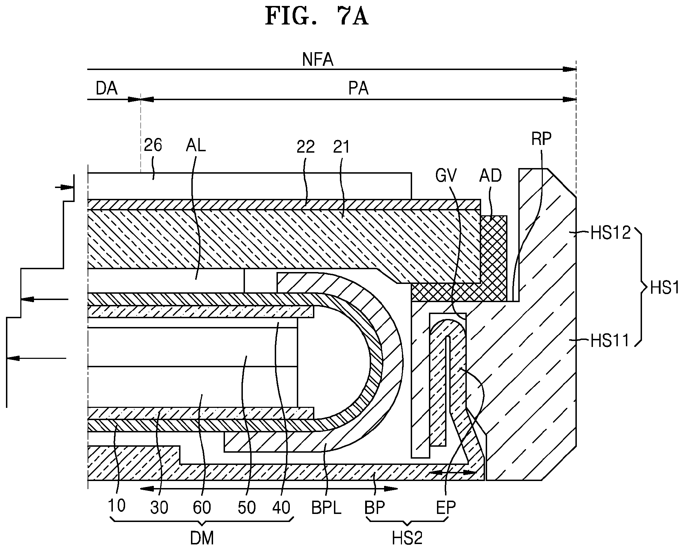

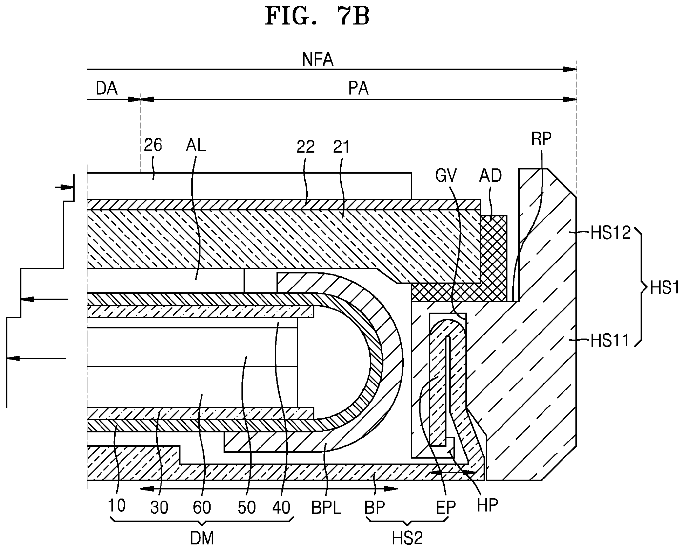

FIGS. 7A and 7B are schematic cross-sectional views of a display apparatus according to some embodiments and may be similar to FIG. 4. Since the display apparatus according to an embodiment is similar to the display apparatus described above, only differences between the two display apparatuses may be described below for economy of description.

Referring to FIG. 7A, the shape and characteristics of the cover window 20 are similar to FIG. 6, but embodiments of the present invention are not necessarily limited thereto. For example, the cover window 20 may be provided as shown in FIG. 4.

In an embodiment, the housing HS may be connected and fixed to another module, such as a case. In an embodiment, the housing HS may include the first housing HS1 and the second housing HS2.

The first housing HS1 may be arranged around the display module DM. In an embodiment, the first housing HS1 may extend along the perimeter of the display module DM and may shield the side of the display module DM. For example, in a plan view, the first housing HS1 may surround the entire circumference of the display module DM.

In this case, in an embodiment, the first housing HS1 may have the recessed portion RP recessed toward the inside of the first housing HS1. The recessed portion RP may be concavely recessed towards the inside of the first housing HS1. For example, the first housing HS1 may include a first portion HS11 and a second portion HS12. The first portion HS11 may be arranged along the periphery of the display module DM. For example, the first portion HS11 may surround the display module DM, particularly, the side of the display module 10. The second portion HS12 may protrude from the upper surface of the first portion HS11. The second portion HS12 may protrude (e.g., in the z direction) from the outside of the upper surface of the first portion HS11 and accordingly, the recessed portion RP may be formed inside the upper surface of the first portion HS11. The cover window 20, for example, the circumference of the window 21, may be arranged in the recessed portion RP. The cover window 20, for example, the circumference of the window 21, may be arranged in the upper surface of the first portion HS11 and the recessed portion RP may expose the upper portion of the cover window 20. The cover window 20, for example, the circumference of the window 21, may be fixedly attached to the recessed portion RP through the adhesive member AD.

In an embodiment, the first housing HS1, particularly the first portion HS11, may have a groove GV that is open from the lower portion to the upper portion. The groove GV may be open from the lower portion to the upper portion of the first portion HS11. In an embodiment, the groove GV may be arranged at both ends in the second direction (e.g., the y direction) of the first housing HS1. In addition, the groove GV may extend in the first direction (e.g., the x direction) from both ends in the second direction of the first housing HS1. For example, in an embodiment the groove GV may extend parallel to the folding axis FAX extending in the first direction (e.g., the x direction). In an embodiment, a portion of the groove GV opening from the lower portion to the upper portion of the first portion HS11 may have a width that narrows in the second direction.

The second housing HS2 may be disposed on the lower surface of the display module DM. In an embodiment, the second housing HS2 may cover the lower surface of the display module DM and may be fixedly connected to another module such as a case. In an embodiment, the second housing HS2 may be a separate member from the first housing HS1.

The second housing HS2 may include a bottom plate BP and an elastic portion EP protruding (e.g., in the z direction) to the upper portion from the lower plate BP and the bottom plate BP so as to be inserted into the groove GV.

The elastic portion EP may extend from the second housing HS2, particularly from the bottom plate BP to the groove GV, for example, to the upper portion, and the elastic portion EP may extend in a direction towards the folding axis FAX, that is, to be inclined towards the inside of the groove GV. In addition, in an embodiment the elastic portion EP may extend vertically into the groove GV protruding towards an upper portion of the groove GV and bent in a direction toward the folding axis FAX so as to form a reverse "U" shape. The outer end of the elastic portion EP having a reverse "U" shape may be connected to the bottom plate BP. In an embodiment, the elastic portion EP may include a leaf spring having an elastic force.

In an embodiment, the elastic portion EP may be arranged at both ends of the second housing HS2 in the second direction (e.g., the y direction). In addition, the elastic portion EP may extend in the first direction (e.g., the x direction) from each of both ends of the second housing HS2 in the second direction. For example, the elastic portion EP may extend in a direction parallel to the folding axis FAX extending in the first direction. In an embodiment, a plurality of elastic portions EP may be provided and the plurality of elastic portions EP may be arranged to be spaced apart from each other along the first direction (e.g., the x direction) from both ends of the second housing HS2 in the second direction (e.g., the y direction).

In an embodiment, the bottom portion BP may cover the lower surface of the display module DM and at least a portion of the bottom portion BP may overlap and be fixed to the lower surface of the display module DM. When the display apparatus 1 is folded with respect to the folding axis FAX such that the display surfaces face each other, layers arranged below the window 21, which is the folding neutral surface, may slip in a direction towards the folding axis FAX, and layers disposed on the window, which is the folding neutral surface, may slip in a direction away from the folding axis FAX. For example, the lower layer of the display module DM may slip in a direction towards the folding axis FAX and, since the bottom plate BP is attached and fixed to the lower surface of the display module DM, the bottom plate BP may also move in the direction towards the folding axis FAX together with the lower layer of the display module DM. In this embodiment, the elastic portion EP connected to the bottom plate BP and inserted into the groove GV may be elastically moved in the second direction (e.g., the y direction) in the groove GV. For example, when folding and unfolding the display apparatus 1, the elastic portion EP may reciprocate elastically in the second direction (e.g., the y direction) in the groove GV, and accordingly, the second housing HS2, for example, the bottom plate BP, may reciprocate in the second direction (e.g., the y direction).

According to embodiments as described above, as the window 21 is attached and fixed to the recessed portion RP, the window 21, as the folding neutral surface, may not slip. Accordingly, the second portion HS12 of the first housing HS1 may be positioned more adjacent to the circumference of the window 21, thereby reducing the area of the non-display area. As a comparative example, if the folding neutral surface is not the window 21, for example, if the lower surface of the display module DM is set to be the folding neutral surface, since the window 21 slips in a direction (e.g., the +y direction) away from the folding axis FAX, a predetermined spare distance is required between the second portion HS12 and the circumference of the window 21. The above arrangement may increase the area of the non-display area.

In addition, according to an embodiment, as the window 21 is set as the folding neutral surface, the lower layer of the display module DM, for example, the cushion layer 60, may slip. However, since the elastic portion EP may reciprocate elastically in the groove GV, even when the bottom plate BP is fixedly attached to the display module DM, the bottom plate BP may move as the display module DM slips. Accordingly, damage to the display module DM, caused by the separation of the housing HS2 attached to the display module DM when the display module DM slips, or a failure such as a crease caused by the slipping of the display module DM may be prevented.

Referring to FIG. 7B, in an embodiment, the first housing HS1 may further include a hook portion HP. The hook portion HP may protrude to a direction opposite to a bending direction of the elastic portion EP. For example, the hook portion HP may extend towards a direction away from the folding axis FAX in the groove GV and then bend to the upper portion to form an approximate "U" shape. The "U" shaped hook portion HP may be coupled to the reverse "U" shaped elastic portion EP such that the second housing HS2 is firmly coupled to the first housing HS1.

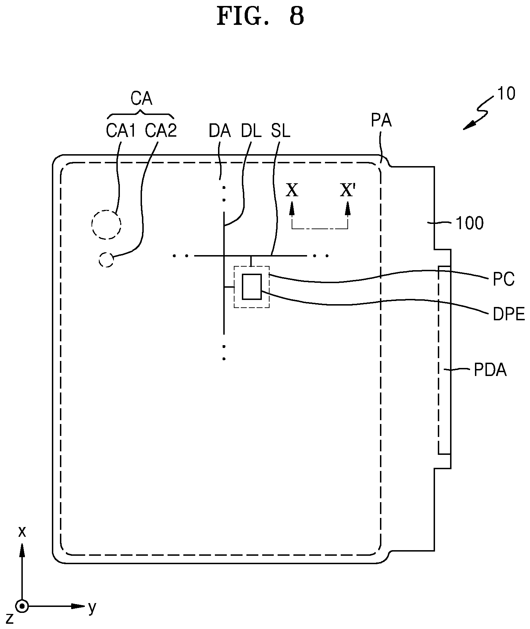

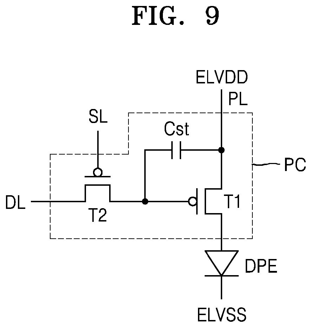

FIG. 8 is a schematic plan view of the display panel 10 included in the display apparatus according to an embodiment, and FIG. 9 is a schematic equivalent circuit diagram of a pixel circuit PC of the display panel 10 and the display element DPE connected to the pixel circuit PC.

Referring to FIGS. 8 and 9, in an embodiment the display panel 10 may include a display area DA, a component area CA, and a peripheral area PA. In an embodiment, the display panel 10 may include a substrate 100, the pixel circuit PC, a scan line SL, a data line DL, a driving voltage line PL, and the display element DPE. In an embodiment, the display area DA, the component area CA, and the peripheral area PA may be defined in the substrate 100. For example, the substrate 100 may include the display area DA, the component area CA, and the peripheral area PA. Hereinafter, an embodiment in which the substrate 100 includes the display area DA, the component area CA, and the peripheral area PA is mainly described in detail for economy of description. However, embodiments of the present invention are not necessarily limited thereto.

The pixel circuit PC and the display element DPE may overlap at least one of the display area DA and the component area CA. In an embodiment, the pixel circuit PC may include a driving thin-film transistor T1, a switching thin-film transistor T2, and a storage capacitor Cst. The display element DPE may emit red, green, or blue light, or emit red, green, blue, or white light. However, embodiments of the present invention are not necessarily limited thereto and the display element DPE may emit one or more of various different colors.

The switching thin-film transistor T2 may be connected to the scan line SL and the data line DL and may transfer a data voltage or data signal input from the data line DL to the driving thin-film transistor T1 based on a scan voltage or scan signal input from the scan line SL.

The storage capacitor Cst may be connected to the switching thin-film transistor T2 and the driving voltage line PL and may store a voltage corresponding to the difference between a voltage received from the switching thin-film transistor T2 and a first power supply voltage ELVDD supplied to the driving voltage line PL.

The driving thin-film transistor T1 is connected to the driving voltage line PL and the storage capacitor Cst and may be configured to control a driving current flowing through the display element DPE from the driving voltage line PL in response to a voltage value stored in the storage capacitor Cst. The display element DPE may emit light having certain luminance according to the driving current. A second power supply voltage ELVSS may be supplied to an opposite electrode (e.g., a cathode) of the display element DPE.

FIG. 9 shows that the pixel circuit PC includes two thin-film transistors and one storage capacitor. However, embodiments of the present invention are not necessarily limited thereto. For example, the pixel circuit PC may include three or more thin-film transistors in some embodiments.

At least a portion of the component area CA may be surrounded by the display area DA (e.g., in a plan view). For example, in an embodiment, the component area CA may be entirely surrounded by the display area DA (e.g., in a plan view). The component area CA may include a pixel area in which the display element DPE is arranged and a transmission area in which the display element DPE is not arranged. Thus, the light transmittance of the display panel 10 in the component area CA may be greater than the light transmittance of the display panel 10 in the display area DA. In an embodiment, the component area CA may include the first component area CA1 and the second component area CA2. However, embodiments of the present invention are not necessarily limited thereto and the component area CA may include three or more component areas in some embodiments.

The peripheral area PA may be arranged outside the display area DA (e.g., in a plan view). In an embodiment, the peripheral area PA may surround the display area DA (e.g., in a plan view). In an embodiment, a scan driver configured to provide a scan signal to the pixel circuit PC, a data driver configured to provide a data signal, and a power line configured to provide the first power voltage ELVDD and/or the second power voltage ELVSS may be arranged in the peripheral area PA. The peripheral area PA may include a pad area PDA. In an embodiment, a pad may be arranged in the pad area PDA, and a display circuit board may be connected to the pad.

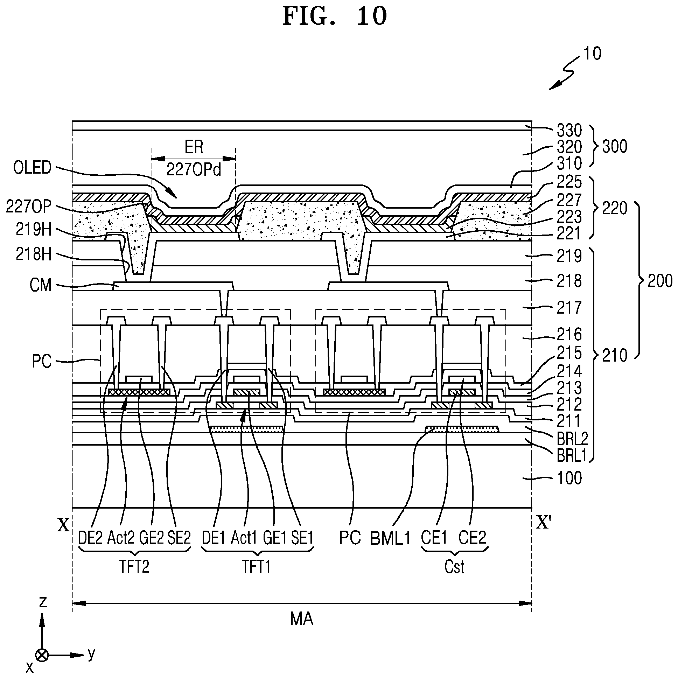

FIG. 10 is a schematic cross-sectional view of the display apparatus of FIG. 8, taken along line X-X' in FIG. 8. As shown in FIG. 10, in an embodiment the display panel 10 may include the substrate 100, a display layer 200, an encapsulation layer 300, a touch sensor layer, and an anti-reflective layer. In an embodiment, the substrate 100 may include a polymer resin such as polyethersulfone, polyacrylate, polyetherimide, polyethylene naphthalate, polyethylene terephthalate, polyphenylene sulfide, polyimide, polycarbonate, cellulose tri acetate, and cellulose acetate propionate. In an embodiment, the substrate 100 may have a multi-layer structure including a base layer having a polymer resin, and a barrier layer. The substrate 100 including a polymer resin may have flexible, rollable, or bendable characteristics.

The display layer 200 may be disposed on the substrate 100 (e.g., disposed directly thereon in the z direction). The display layer 200 may include a pixel circuit layer 210 and a display element layer 220.

In an embodiment, the pixel circuit layer 210 may include a first barrier layer BRL1, a first metal layer BML1, a second barrier layer BRL2, the pixel circuit PC, a connection electrode CM, and a plurality of insulating layers. In an embodiment, the pixel circuit PC may include a first thin-film transistor TFT1, a second thin-film transistor TFT2, and a storage capacitor Cst. The first thin-film transistor TFT1 may include a first semiconductor layer Act1, a first gate electrode GE1, a first source electrode SE1, and a first drain electrode DE1. The second thin-film transistor TFT2 may include a second semiconductor layer Act2, a second gate electrode GE2, a second source electrode SE2, and a second drain electrode DE2. The storage capacitor Cst may include a first electrode CE1 and a second electrode CE2. In an embodiment, the plurality of insulating layers may include a buffer layer 211, a first inorganic insulating layer 212, a second inorganic insulating layer 213, an intermediate insulating layer 214, a third inorganic insulating layer 215, a fourth inorganic insulating layer 216, a first organic insulating layer 217, a second organic insulating layer 218, and a third organic insulating layer 219.

The first barrier layer BRL1 may be disposed on the substrate 100 (e.g., disposed directly thereon in the z direction). In an embodiment, the first barrier layer BRL1 may include an inorganic material such as silicon oxide (SiOₓ), silicon nitride (SiNₓ), or silicon oxynitride (SiO_{X}N_{Y}).

In some embodiments, the first barrier layer BRL1 may include amorphous silicon (a-Si). In an embodiment, the first barrier layer BRL1 may be a single layer or multiple layers including the above materials.

The first metal layer BML1 may be disposed on the first barrier layer BRL1 (e.g., disposed directly thereon in the z direction). The first metal layer BML1 may overlap the first thin-film transistor TFT1 (e.g., in the z direction). In an embodiment, the first metal layer BML1 may function as a lower protection metal protecting a layer overlapping the first metal layer BML1. In an embodiment, the first metal layer BML1 may not overlap the second thin-film transistor TFT2 (e.g., in the z direction). In an embodiment, a constant voltage and a signal may be applied to the first metal layer BML1. The first metal layer BML1 may be configured to more easily supply charges to a back channel of the pixel circuit PC. In an embodiment, the first metal layer BML1 may include aluminum (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu). In an embodiment, the first metal layer BML1 may include a doped a-Si. The first metal layer BML1 may be a single layer or multiple layers including the above materials.

The second barrier layer BRL2 may be disposed on the first barrier layer BRL1 (e.g., disposed directly thereon in the z direction). In an embodiment, the second barrier layer BRL2 may include an inorganic material such as SiOₓ, SiNₓ, or SiO_{X}N_{Y}. In some embodiments, the second barrier layer BRL2 may include an a-Si. In an embodiment, the second barrier layer BRL2 may be a single layer or multiple layers including the above materials.

The buffer layer 211 may be disposed on the second barrier layer BRL2 (e.g., disposed directly thereon in the z direction). In an embodiment, the buffer layer 211 may include an inorganic material such as SiOₓ, SiNₓ, or SiO_{X}N_{Y} and may have a single-layer or multi-layer structure including the inorganic materials described above.

The first semiconductor layer Act1 may be disposed on the buffer layer 211 (e.g., disposed directly thereon in the z direction). The first semiconductor layer Act1 may include a silicon semiconductor. In an embodiment, the first semiconductor layer Act1 may include polysilicon. The first semiconductor layer Act1 may include a channel area and a drain area and a source area respectively arranged in both sides of the channel area. In some embodiments, the first semiconductor layer Act1 may include an organic semiconductor or an oxide semiconductor.

The first inorganic insulating layer 212 may be disposed on (e.g., disposed directly thereon) the first semiconductor layer Act1. In an embodiment, the first inorganic insulating layer 212 may include an inorganic insulating material such as SiOₓ, SiNₓ, or SiO_{X}N_{Y}. For example, the first inorganic insulating layer 212 may include at least one of SiOx, SiNₓ, and SiO_{X}N_{Y}. In an embodiment, the first inorganic insulating layer 212 may include aluminum oxide (Al₂O₃), titanium oxide (TiO₂), a tantalum oxide (Ta₂O₅), hafnium oxide (HfO₂), or a zinc oxide (ZnO).

The first gate electrode GE1 may be disposed on the first inorganic insulating layer 212 (e.g., disposed directly thereon in the z direction). The first gate electrode GE1 may overlap the first semiconductor layer Act1 (e.g., in the z direction). In an embodiment, the first gate electrode GE1 may include Mo. The first gate electrode GE2 may include Al, Pt, Pd, Ag, Mg, Au, Ni, Nd, Ir, Cr, Ca, Mo, Ti, W, and/or Cu, and may be a single layer or multiple layers including the above materials.

The second inorganic insulating layer 213 may be disposed on (e.g., disposed directly thereon) the first gate electrode GE1. In an embodiment, the second inorganic insulating layer 213 may include an inorganic insulating material such as SiOₓ, SiNₓ, or SiO_{X}N_{Y}. For example, the second inorganic insulating layer 213 may include at least one of SiOx, SiNₓ, and SiO_{X}N_{Y}. In an embodiment, the second inorganic insulating layer 213 may include Al₂O₃, TiO₂, Ta₂O₅, HfO₂, or ZnO.

The second electrode CE2 may be disposed on the second inorganic insulating layer 213 (e.g., disposed directly thereon in the z direction). In an embodiment, the second electrode CE2 may overlap the first gate electrode GE1 (e.g., in the z direction). The second electrode CE2 may constitute a first gate electrode GE1 overlapping the second electrode CE2 with the second inorganic insulating layer 213 therebetween and the storage capacitor Cst. For example, in an embodiment the first gate electrode GE1 may function as the first electrode CE1 of the storage capacitor Cst. As described above, the storage capacitor Cst may overlap the first thin-film transistor TFT1 (e.g., in the z direction). In some embodiments, the storage capacitor Cst may not overlap the first thin-film transistor TFT1 (e.g., in the z direction). In an embodiment, the second electrode CE2 may include Al, Pt, Pd, Ag, Mg, Au, Ni, Nd, Ir, Cr, Ca, Mo, Ti, W, and/or Cu, and may be a single layer or multiple layers including the above materials.

The interlayer insulating layer 214 may be disposed on (e.g., disposed directly thereon) the second electrode CE2. In an embodiment, the intermediate insulating layer 214 may include an inorganic insulating material such as SiOₓ, SiNₓ, or SiO_{X}N_{Y}. For example, the intermediate insulating layer 214 may include at least one of SiOx, SiNₓ, and SiO_{X}N_{Y}. In an embodiment, the intermediate insulating layer 214 may include Al₂O₃, TiO₂, Ta₂O₅, HfO₂, or ZnO.

The second semiconductor layer Act2 may be disposed on the intermediate insulating layer 214 (e.g., disposed directly thereon in the z direction). The second semiconductor layer Act2 may include a channel area and a drain area and a source area respectively arranged in both sides of the channel area. The second semiconductor layer Act2 may include an oxide semiconductor. For example, in an embodiment, the second semiconductor layer Act2, which is a Zn oxide material, may include zinc (Zn) oxide, In-Zn oxide, Ga-In-Zn oxide, and the like. Alternatively, the second semiconductor layer Act2 may include a semiconductor, such as In-Ga-Zn-O (IGZO), In-Sn-Zn-O (ITZO), or In-Ga-Sn-Zn-O (IGTZO), in which metals, such as indium (In), gallium (Ga), and/or tin (Sn) are contained in ZnO.

In an embodiment, the source area and drain area of the second semiconductor layer Act2 may be formed by controlling a carrier concentration of the oxide semiconductor and making the oxide semiconductor conductive. For example, in an embodiment the source area and the drain area of the second semiconductor layer Act2 may be formed by increasing the carrier concentration through plasma treatment of the oxide semiconductor by using hydrogen-based gas, fluorine-based gas, or a combination thereof.

The third inorganic insulating layer 215 may be disposed on (e.g., disposed directly thereon) the second semiconductor layer Act2. In an embodiment, the third inorganic insulating layer 215 may include an inorganic insulating material such as SiOₓ, SiNₓ, or SiO_{X}N_{Y}. For example, the third inorganic insulating layer 215 may include at least one of SiOx, SiNₓ, and SiO_{X}N_{Y}. In an embodiment, the third inorganic insulating layer 215 may include Al₂O₃, TiO₂, Ta₂O₅, HfO₂, or ZnO.

The second gate electrode GE2 may be disposed on the third inorganic insulating layer 215 (e.g., disposed directly thereon in the z direction). The second gate electrode GE2 may overlap the second semiconductor layer Act2. The second gate electrode GE2 may overlap the channel area of the second semiconductor layer Act2. In an embodiment, the second gate electrode GE2 may include Al, Pt, Pd, Ag, Mg, Au, Ni, Nd, Ir, Cr, Ca, Mo, Ti, W, and/or Cu, and may be a single layer or multiple layers including the above materials.

The fourth inorganic insulating layer 216 may be disposed on (e.g., disposed directly thereon) the second gate electrode GE2. In an embodiment, the fourth inorganic insulating layer 216 may include an inorganic insulating material such as SiOₓ, SiNₓ, or SiO_{X}N_{Y}. For example, the fourth inorganic insulating layer 216 may include at least one of SiOx, SiNₓ, and SiO_{X}N_{Y}. In an embodiment, the fourth inorganic insulating layer 216 may include Al₂O₃, TiO₂, Ta₂O₅, HfO₂, or ZnO. The fourth insulating layer 216 may be a single layer or multiple layers including the above inorganic insulating materials.

The first source electrode SE1 and the first drain electrode DE1 may be disposed on the fourth inorganic insulating layer 216 (e.g., disposed directly thereon in the z direction). The first source electrode SE1 and the first drain electrode DE1 may be connected to (e.g., directly connected thereto) the first semiconductor layer Act1. In an embodiment, the first source electrode SE1 and the first drain electrode DE1 may each be connected to the first semiconductor layer Act1 through a contact hole of the insulating layers. For example, the first source electrode SE1 and the first drain electrode DE1 may each be connected to the first semiconductor layer Act1 through the contact hole of the first inorganic insulating layer 212, the contact hole of the second inorganic insulating layer 213, the contact hole of the intermediate insulating layer 214, the contact hole of the third inorganic insulating layer 215, and the contact hole of the fourth inorganic insulating layer 216. The contact hole of the first inorganic insulating layer 212, the contact hole of the second inorganic insulating layer 213, the contact hole of the intermediate insulating layer 214, the contact hole of the third inorganic insulating layer 215, and the contact hole of the fourth inorganic insulating layer 216 may overlap each other.

The second source electrode SE2 and the second drain electrode DE2 may be disposed on the fourth inorganic insulating layer 216 (e.g., disposed directly thereon in the z direction). The second source electrode SE2 and the second drain electrode DE2 may be connected to the second semiconductor layer Act2. The second source electrode SE2 and the second drain electrode DE2 may each be connected to the second semiconductor layer Act2 through the contact hole of the third inorganic insulating layer 215 and the contact hole of the fourth inorganic insulating layer 216, respectively.

The first source electrode SE1, the first drain electrode DE1, the second source electrode SE2, and the second drain electrode DE2 may include a material having good conductivity. In an embodiment, the first source electrode SE1, the first drain electrode DE1, the second source electrode SE2, and the second drain electrode DE2 may include a conductive material including Mo, Al, Cu, and Ti and may be a single layer or multiple layers including the above material. In an embodiment, the first source electrode SE1, the first drain electrode DE1, the second source electrode SE2, and the second drain electrode DE2 may have a multilayer structure of Ti/Al/Ti.

In an embodiment, the first thin-film transistor TFT1 including the first semiconductor layer Act1 including the silicon semiconductor, which has a high reliability, may be used as a driving thin-film transistor to implement the display panel 10 having a high quality.

Since an oxide semiconductor has high carrier mobility and low leakage current, voltage drop is not great even when a driving time is long. For example, since a color change in images according to the voltage drop is not noticeable even during a low-frequency operation, the display apparatus may operate at a low frequency. As such, since the oxide semiconductor has a low leakage current, an oxide semiconductor may be used in at least one thin-film transistor excluding the driving thin-film transistor, thereby preventing a leakage current and, at the same time, reducing power consumption For example, the second thin-film transistor TFT2 may include the second semiconductor layer Act2 including an oxide semiconductor.

The first organic insulating layer 217 may cover the first source electrode SE1, the first drain electrode DE1, the second source electrode SE2, and the second drain electrode DE2. The first organic insulating layer 217 may include an organic material. For example, in an embodiment the first organic insulating layer 217 may include an organic insulating material, such as a general-purpose polymer, such as polymethylmethacrylate (PMMA) or polystyrene (PS), polymer derivatives having a phenol-based group, acryl-based polymers, imide-based polymers, arylether-based polymers, amide-based polymers, fluorine-based polymers, p-xylene-based polymers, vinyl alcohol-based polymers, and a blend thereof.

The connection electrode CM may be disposed on the first organic insulating layer 217 (e.g., disposed directly thereon in the z direction). The connection electrode CM may be connected to the first drain electrode DE1 or the first source electrode SE1 through a contact hole of the first organic insulating layer 217. The connection electrode CM may include a material with good conduction. In an embodiment, the connection electrode CM may include a conductive material including Mo, Al, Cu, Ti, etc. and may have a single-layer or multi-layer structure including the above materials. In an embodiment, the connection electrode CM may have a multi-layer structure of Ti/Al/Ti.

The second organic insulating layer 218 and the third organic insulating layer 219 may be disposed on the connection electrode CM. The second organic insulating layer 218 and the third organic insulating layer 219 may include an organic material. For example, in an embodiment at least one of the second organic insulating layer 218 and the third organic insulating layer 219 may include an organic insulating material, such as a general-purpose polymer, such as PMMA or PS, polymer derivatives having a phenol-based group, acryl-based polymers, imide-based polymers, arylether-based polymers, amide-based polymers, fluorine-based polymers, p-xylene-based polymers, vinyl alcohol-based polymers, and a blend thereof. Since the second organic insulating layer 218 and the third organic insulating layer 219 are sequentially stacked (e.g., in the z direction), the display element layer 220 may be disposed on a flat pixel circuit layer 210. However, embodiments of the present invention are not necessarily limited thereto. For example, in some embodiments, the third organic insulating layer 219 may be omitted.

The display element layer 220 may be disposed on the pixel circuit layer 210. The display element layer 220 may include a display element, such as an organic light-emitting diode OLED. A plurality of organic light-emitting diodes OLED may be included in the display area DA. For example, the plurality of organic light-emitting diodes OLED may be arranged in the display area DA. In an embodiment, the organic light-emitting diode OLED may include a pixel electrode 221, an emission layer 223, an opposite electrode 225, and a pixel-defining layer 227.

The pixel electrode 221 may be arranged on the third organic insulating layer 219. In an embodiment, the pixel electrode 221 may be connected to (e.g., directly connected thereto) the connection electrode CM through a contact hole 218H of the second organic insulating layer 218 and a contact hole 219H of the third organic insulating layer 219. In an embodiment, the pixel electrode 221 may include a conductive oxide, such as indium tin oxide (ITO), indium zinc oxide (IZO), ZnO, indium oxide (In₂O₃), indium gallium oxide (IGO), or aluminum zinc oxide (AZO). In some embodiments, the pixel electrode 221 may include a reflective layer including Ag, Mg, Al, Pt, Pd, Au, Ni, Nd, Ir, Cr, or a compound thereof. However, embodiments of the present invention are not necessarily limited thereto. For example, in an embodiment, the pixel electrode 221 may further include a layer formed of ITO, IZO, ZnO, or In₂O₃ over/under the above reflection layer.

The pixel-defining layer 227 may have an opening 227OP exposing at least a portion of the pixel electrode 221. The opening 227OP of the pixel-defining layer 227 may define an emission area ER of the organic light-emitting diode OLED. The emission area ER of the organic light-emitting diode OLED may refer to a subpixel. In an embodiment, the pixel-defining layer 227 may include a plurality of openings 227OP. The plurality of openings 227OP may define a plurality of emission areas ER of the plurality of organic light-emitting diodes OLED.

The pixel-defining layer 227 may include an organic insulating material. In some embodiments, the pixel-defining layer 227 may include an inorganic insulating material such as SiOₓ, SiNₓ, or SiOₓN_{y}. In some embodiments, the pixel-defining layer 227 may include an organic insulating material and an inorganic insulating material. In some embodiments, the pixel-defining layer 227 may include a light shield material and may be provided in black. In an embodiment, the light shield material may include a resin or paste including carbon black, carbon nanotube, or black dyes, metal particles such as Ni, Al, Mo, and an alloy thereof, metal oxide particles (for example, chrome oxide), or metal nitride particles (for example, chrome nitride). In an embodiment in which the pixel-defining layer 227 includes a light shield material, external light reflection may be reduced by metal structures disposed below the pixel-defining layer 227.

The emission layer 223 may be arranged in the opening 227OP of the pixel-defining layer 227. The emission layer 223 may include a high molecular-weight or low molecular-weight organic material emitting a predetermined color of light. In an embodiment, a first functional layer and a second functional layer may be disposed below and above the emission layer 223 (e.g., in the z direction). The first functional layer may include, for example, a hole transport layer or both a hole transport layer and a hole injection layer. The second functional layer is an element disposed on the emission layer 223 and is optional. The second functional layer may include an electron transport layer and/or an electron injection layer. The first functional layer and/or the second functional layer may be a common layer formed to entirely cover the substrate 100, like the opposite electrode 225 to be described later.

The opposite electrode 225 may be disposed on the emission layer 223. The opposite electrode 225 may include a conductive material having a low work function. For example, in an embodiment the opposite electrode 225 may include a transparent (or transflective) layer including Ag, Mg, Al, Pt, Pd, Au, Ni, Nd, Ir, Cr, Li, Ca, or an alloy thereof. Alternatively, the opposite electrode 225 may further include a layer, such as ITO, IZO, ZnO, or In₂O₃, on the transparent (or transflective) layer including the above material. In some embodiments, a capping layer may be further disposed on the opposite electrode 225. In an embodiment, the capping layer may include lithium fluoride (LiF), an inorganic material, or/and an organic material.

The encapsulation layer 300 may be disposed on the display element layer 220 (e.g., in the z direction). The encapsulation layer 300 may protect the display element layer 220. In an embodiment, the encapsulation layer 300 may include at least one inorganic encapsulation layer and at least one organic encapsulation layer. In an embodiment, the at least one inorganic encapsulation layer may include at least one inorganic material among Al₂O₃, TiO₂, Ta₂O₅, ZnO, SiOₓ, SiNₓ, and SiO_{X}N_{Y}. The at least one organic encapsulation layer may include a polymer-based material. Examples of the polymer-based material may include an acrylic resin, an epoxy resin, polyimide, and polyethylene. In an embodiment, the at least one organic encapsulation layer may include acrylate. In an embodiment, the encapsulation layer 300 may include a first inorganic encapsulation layer 310, an organic encapsulation layer 320, and a second inorganic encapsulation layer 330 that are sequentially stacked (e.g., in the z direction).

In the above, for convenience of explanation, the display apparatus including the organic light-emitting diode as the display element was described. However, embodiments may be applied to various display apparatuses such as a liquid crystal display apparatus, an electrophoretic display apparatus, an inorganic electroluminescent (EL) display apparatus, etc.

The display apparatus according to embodiments of the present invention may be an electronic apparatus (e.g., an electronic device) such as a smartphone, a mobile phone, a smart watch, a navigation apparatus, a game machine, a television (TV), a vehicle head unit, a notebook computer, a laptop computer, a tablet computer, a personal media player (PMP), or personal digital assistants (PDA). Also, the electronic apparatus may be a flexible apparatus. However, embodiments of the present invention are not necessarily limited thereto and the electronic device that the display device DD may be applied to may be various different small-sized, medium-sized or large-sized electronic devices.

According to embodiments of the present invention, the display apparatus including the display panel with an increased display area and a reduced weight and increased durability may be provided.

The effects of embodiments of the present invention are not limited to the above, and other effects may be understood by those of ordinary skill in the art.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the present invention.

## Claims

1. A display apparatus (1) including a folding area (FA) comprising a folding axis (FAX) extending in a first direction and a non-folding area (NFA) adjacent to the folding area (FA), the folding area (FA) is foldable with respect to the folding axis (FAX), the display apparatus (1) comprising:
a display module (DM) comprising an upper surface having a display surface, and a lower surface having a non-display surface;
a window (21) disposed on the upper surface of the display module (DM); and
a housing (HS) accommodating the display module (DM) and the window (21) therein, wherein
the housing (HS) comprises:
a first housing (HS1) surrounding a circumference of the display module (DM) and comprising a recessed portion (RP) recessed towards an inside of the first housing (HS1), wherein a circumference of the window (21) is disposed in the recessed portion (RP); and
a second housing (HS2) separated from the first housing (HS1) and disposed on the lower surface of the display module (DM), the second housing (HS2) is slidable with respect to the display module (DM) when the display module (DM) is folded.

2. The display apparatus (1) of claim 1, wherein a width of the window (21) in a second direction crossing the first direction is greater than a width of the display module (DM) in the second direction.

3. The display apparatus (1) of claim 1 or 2, wherein the first housing (HS1) exposes an upper portion of the window (21) disposed in the recessed portion (RP).

4. The display apparatus (1) of at least one of claims 1 to 3, wherein an adhesive member (AD) fixedly attaches a circumference of the window (21) onto the recessed portion (RP) of the first housing (HS1) and arranges a folding neutral surface on the window (21).

5. The display apparatus (1) of claim 4, wherein the adhesive member (AD) surrounds a lower surface and a surface of the circumference of the window (21).

6. The display apparatus (1) of at least one of claims 1 to 5, wherein:
when the display apparatus (1) is folded, layers of the display module (DM) disposed below the window (21) slip towards the folding axis (FAX); and
layers of the display module (DM) disposed above the window (21) slip in a direction away from the folding axis (FAX).

7. The display apparatus (1) of at least one of claims 1 to 6, wherein a thickness of the window (21) in the folding area (FA) is less than a thickness of the window (21) in the non-folding area (NFA).

8. The display apparatus (1) of claim 7, wherein the thickness of the window (21) in a transformation area of the non-folding area (NFA) adjacent to the folding area (FA) gradually increases in a direction away from the folding area (FA).

9. The display apparatus (1) of claim 7 or 8, further comprising a window planarization layer (22) disposed on the window (21), wherein the window planarization layer (22) has a thickness compensating for the thickness of the window (21), wherein a sum of the thickness of the window planarization layer (22) and the thickness of the window (21) is the same in the folding area (FA) and in the non-folding area (NFA).

10. The display apparatus (1) of at least one of claims 1 to 9, wherein a thickness of a first portion (HS11) of the window (21) arranged in the recessed portion (RP) is greater than a thickness of a second portion (HS12) of the window (21) not arranged in the recessed portion (RP).

11. The display apparatus (1) of at least one of claims 1 to 10, wherein the first housing (HS1) comprises a first portion (HS11) and a second portion (HS12) protruding from an upper surface of the first portion (HS11) to define the recessed portion (RP).

12. A display apparatus (1), especially according to at least one of claims 1 to 11, including a folding area (FA) comprising a folding axis (FAX) extending in a first direction and a non-folding area (NFA) adjacent to the folding area (FA), the display apparatus (1) comprising:
a display module (DM) foldable with respect to the folding axis (FAX);
a window (21) disposed on an upper surface of the display module (DM), the upper surface of the display module (DM) comprises a display surface; and
a housing (HS) accommodating the display module (DM) and the window (21), wherein
the housing (HS) comprises:
a first housing (HS1) surrounding a circumference of the display module (DM) and comprising a groove (GV) that is open from a lower portion of the first housing (HS1) to an upper portion of the first housing (HS1); and
a second housing (HS2) disposed on a lower surface of the display module (DM) and comprising an elastic portion (EP) disposed in the groove (GV) and protruding towards an upper portion of the groove (GV).

13. The display apparatus (1) of claim 12, wherein the elastic portion (EP) protrudes in the groove (GV) towards the upper portion of the groove (GV) and bends in a direction towards the folding area (FA), the elastic portion (EP) having a reverse "U" shape.

14. The display apparatus (1) of claim 12 or 13, wherein, in a plan view, the elastic portion (EP) is arranged on both sides of the second housing (HS2) in a second direction crossing the first direction,
wherein, when the display apparatus (1) is folded or unfolded, the elastic portion (EP) reciprocates elastically in the second direction in the groove (GV) and the second housing (HS2) reciprocates in the second direction.

15. The display apparatus (1) of at least one of claims 12 to 14, wherein the second housing (HS2) is fixedly attached to the lower surface of the display module (DM).

16. The display apparatus (1) of at least one of claims 12 to 15, wherein, in a plan view, a plurality of elastic portions (EP) are spaced apart from each other along the first direction.

17. The display apparatus (1) of at least one of claims 13 to 16, wherein:
the first housing (HS1) further comprises a hook portion (HP) extending in a direction away from the folding axis (FAX) in the groove (GV) and protruding towards the upper portion of the groove (GV), the hook portion (HP) having a "U" shape, and
the hook portion (HP) is coupled to the elastic portion (EP).

18. The display apparatus (1) of at least one of claims 12 to 17, wherein a circumference of the window (21) is disposed in and attached onto the first housing (HS1),
wherein the first housing (HS1) exposes an upper portion of the window (21) arranged in the first housing (HS1).

19. The display apparatus (1) of at least one of claims 12 to 18, wherein the elastic portion (EP) comprises a leaf spring.

20. An electronic device, comprising:
a display apparatus (1) according to at least one of claims 1 to 19.
